# EUROPÄISCHE PATENTSCHRIFT

(11) **EP 2 102 896 B1**
(45) Veröffentlichungstag und Bekanntmachung des Hinweises auf die Patenterteilung: **03.08.2011**
(21) Anmeldenummer: 07856509.0
(22) Anmeldetag: 10.12.2007
(51) Int. Cl.: H01L 21/00

(54) **VORRICHTUNG UND VERFAHREN ZUM REINIGEN VON GEGENSTÄNDEN, INSBESONDERE VON DÜNNEN SCHEIBEN**
DEVICE AND METHOD FOR CLEANING ARTICLES, ESPECIALLY THIN WAFERS
DISPOSITIF ET PROCÉDÉ POUR NETTOYER DES OBJETS, EN PARTICULIER DES PLAQUETTES MINCES

(30) Priorität: 15.12.2006 DE 102006059810
(43) Veröffentlichungstag der Anmeldung: 23.09.2009
(73) Patentinhaber: RENA GmbH, 78148 Gütenbach (DE)
(72) Erfinder: BÜRGER, Norbert, 79199 Kirchzarten (DE)
(74) Vertreter: Stürken, Joachim
(86) Internationale Anmeldenummer: PCT/EP2007/010734
(87) Internationale Veröffentlichungsnummer: WO 2008/071364

(56) Entgegenhaltungen:
- DE-A1- 10 020 523
- US-A- 5 069 235
- US-A- 6 139 591
- US-B1- 6 423 146

## Beschreibung

### Technisches Gebiet

Die Erfindung betrifft allgemein eine Vorrichtung und ein Verfahren zum Reinigen von dünnen Scheiben, wie beispielsweise Halbleiterwafern, Glassubstraten, Fotomasken, Compactdiscs oder dergleichen. Insbesondere betrifft die Erfindung eine Vorrichtung und ein Verfahren zum Vorreinigen von Halbleiterwafern, nachdem diese durch Sägen aus einem Block hergestellt worden sind.

### Definitionen

Unter dem Begriff "*dünne Scheiben*" werden erfindungsgemäß solche Gegenstände verstanden, die eine sehr geringe Dicke im Bereich zwischen 80 und 300 µm wie z.B. 150 bis 170 µm aufweisen. Die Form der Scheiben ist beliebig und kannbeispielsweise im Wesentlichen rund (Halbleiterwafer) oder im Wesentlichen rechteckig bzw. quadratisch (Solarwafer) sein, wobei die Ecken wahlweise eckig, abgerundet oder abgeschrägt ausgestaltet sein können. Diese Gegenstände sind aufgrund ihrer geringen Dicke sehr bruchempfindlich. Die Erfindung bezieht sich auf die Vorreinigung derartiger Gegenstände.

Die erfindungsgemäße Vorrichtung und das erfindungsgemäße Verfahren werden nachfolgend aus Verständnisgründen exemplarisch anhand von eckigen Solarwafern (kurz "Wafern") erläutert.

Die Erfindung beschränkt sich jedoch nicht nur auf die Vorreinigung von Wafern. Vielmehr umfasst die Erfindung allgemein die Reinigung von dünnen Scheiben, die sequenziell in einem definierten Abstand zueinander in einer Trägereinrichtung gehalten werden.

### Hintergrund der Erfindung

Für die Herstellung von Wafern ist es notwendig, das Ausgangsmaterial, das in der Regel als rechteckiger Siliziumblock vorliegt und als Substratblock bzw. Ingot bezeichnet wird, auf eine Trägereinrichtung aufzubringen. Diese Trägereinrichtung besteht typischerweise aus einem Metallträger, auf dem wiederum eine Glasplatte als Trägermaterial angebracht ist. Dabei ist der zu bearbeitende Substratblock auf der Glasplatte aufgeklebt. Alternativ hierzu können jedoch auch andere Materialien für die Ausbildung der Trägereinrichtung vorgesehen sein.

Zur Herstellung mehrerer Wafer ist es notwendig, den Substratblock aus mono- oder polykristallinem Silizium scheibenartig vollständig durchzusägen, so dass der jeweilige Sägeschnitt bis in die Glasplatte hineinreicht. Nach dem Sägen z.B. unter Verwendung herkömmlicher Innenlochsägen oder Drahtsägen haftet der auf diese Weise hergestellte Wafer mit einer Längsseite (Kante), nämlich mit derjenigen, die der Trägereinrichtung zugewandt ist, durch die Klebeverbindung weiterhin an der Glasplatte. Nachdem der Substratblock vollständig in einzelne Wafer zerteilt worden ist und sich zwischen den einzelnen Wafern somit ein spaltartiger Zwischen-raum gebildet hat, liegt der ursprüngliche Substratblock in Form eines kammartigen, fächerartigen Gebildes vor.

Zur Durchführung des nassmechanischen Sägeprozesses unter Verwendung einer Präzisionsdrahtsäge werden im Wesentlichen zwei Materialien benötigt, zum einen Siliziumcarbid oder gleichwirkende Partikel mit abrasiven Eigenschaften für die nötige Härte, zum anderen Glykol oder auch Öl als Träger- und Kühlmittel. Korrekt betrachtet ist es gar nicht der Draht, der am Silizium sägt, sondern vielmehr sind es die Siliziumcarbidpartikel, die mit Glykol wie z.B. Polyethylenglykol oder Öl vermengt als sogenannte "Slurry" die Arbeit verrichten. Mit diesem gegebenenfalls weitere chemische Zusätze enthaltenden Medium wird der Draht während des Sägevorgangs gespült. Durch die Bewegung des Drahtes entfalten die Partikel ihre abrasive, d.h. abtragende Wirkung. So werden beispielsweise bei jedem Einschnitt mit einem 160-Mikrometer-Draht ca. 210 Mikrometer Silizium zerrieben. Dieser Verschnitt wird auch als Kerf bezeichnet und kann unter Verwendung dünnerer Drähte mit Duchmessern von z.B. 80 Mikrometer reduziert werden. Während des Sägeprozesses kommt es zu einer Vielzahl von chemischen Reaktionen der beteiligten Reaktionspartner auch an der Waferoberfläche. Zwischen den Wafern befinden sich nach dem Sägen Slurry, Reaktionsprodukte und Konglomerate aus Slurry-Bestandteilen und Silizium, die aufgrund ihrer Konsistenz häufig an der Oberfläche des Wafers anhaften.

Bevor die einzelnen Wafer, die nun jeweils eine scheibenförmige Ausbildung aufweisen, von der Trägereinrichtung entfernt werden, findet eine Vorreinigung (Pre-Cleaning) statt. Durch die Vorreinigung soll die Slurry, die sich in den entstandenen Zwischenräumen jeweils zweier Substrate auf den Oberflächen der Wafer befindet, herausgewaschen werden. Diese Vorreinigung ist Gegenstand der vorliegenden Erfindung.

### Stand der Technik

Aus dem Stand der Technik sind Vorreinigungen zur Entfernung der Slurry bekannt. Sie werden in der Regel von Hand durchgeführt, indem ein Duschkopf, aus dem ein Fluidstrom austritt, von Hand über das kammartige Gebilde geführt wird. Dadurch wird erreicht, dass die in den Spalten des Substratblocks befindliche Slurry zumindest zum Teil ausgeschwemmt wird. Ein überwiegender Anteil verbleibt jedoch in dem spaltartigen Zwischenraum.

Diese manuelle Behandlung gestaltet sich jedoch schwierig, da die Trägereinrichtung von allen Seiten abzuduschen ist und ein Ablaufen der Slurry aufgrund des ständigen Drehens nur teilweise möglich ist. Zudem besteht gerade durch das ständige Wenden der Trägereinrichtung die Gefahr, dass die einzelnen Wafer von der Glasplatte abbrechen und zerstört werden.

Bis die Trägereinrichtung mit den Wafern einem nachfolgenden Bearbeitungsprozess übergeben werden kann, sind die Oberflächen der Wafer in der Regel bereits abgetrocknet. Ferner haftet dort weiterhin Slurry, wodurch der weitere Bearbeitungsprozess stark beeinflusst wird.

Ein gemeinsamer Nachteil dieser manuellen Behandlung liegt darin, dass eine gleichbleibende Qualität und damit standardisierbare und reproduzierbare Ergebnisse bezüglich der Oberflächeneigenschaften nicht gewährleistet werden können.

Ferner sind auch automatisch arbeitende Vorrichtungen zur Vorreinigung von Wafern bekannt. So offenbart die Druckschrift US 6 139 591 A eine Vorrichtung und ein Verfahren zum Separieren und Reinigen von Wafern, wobei der feststehende, die bereits gesägten Wafer umfassende Substratblock mittels einer Duschvorrichtung angesprüht wird, deren zwei gleichzeitig arbeitende Teile beiderseits der Wafer angeordnet sind. Die eine Mehrzahl von Düsen umfassende Duschvorrichtung ist zwar während des Reinigungsvorganges lateral verfahrbar, steht jedoch in Bezug auf den Sprühwinkel fest. Daher werden unter Umständen nicht alle Orte der Waferzwischenräume gleichermaßen gereinigt, und die Gefahr in den Zwischenräumen zurückbleibender Slurry-Reste ist gegeben. Dieses Problem versucht die DE 100 20 523 A1 zu lösen, indem die Wafer während des Reinigungsprozesses relativ zu einer Reinigungsvorrichtung bewegt werden. Die hierzu notwendige Mechanik ist jedoch aufwändig und somit als nachteilig anzusehen. Einen anderen Weg schlägt die Druckschrift US -A- 5 069 235 vor. Hier werden seitlich feststehende Düsenanordnungen verwendet, und die erwünschte Reinigungswirkung wird durch ein vollständiges Eintauchen der Wafer mit nachfolgendem schnellen Entleeren des Behälters erreicht, wobei die Innenkontur des die Wafer beinhaltenden Behälters besonders strömungsgünstig geformt ist. Hierzu ist es jedoch nötig, dass die Wafer bereits in einem für vertikale Strömung durchlässigen Träger und somit bereits vereinzelt vorliegen. Die dort beschriebene Vorrichtung dient daher nicht der eigentlichen Vorreinigung. Auch die Lehre der US 6 423 146 B1 zielt auf bereits vereinzelte Wafer ab, welche zur Reinigung entweder einzeln auf einem rotierbaren Halter ("Chuck") angeordnet sind, oder sich in Mehrzahl in einem um seine Längsachse rotierbaren Halter befinden. Somit weist auch diese Lösung den Nachteil hohen mechanischen Aufwands als auch die Notwendigkeit des Vorliegens bereits vereinzelter Wafer auf.

### Aufgabe der Erfindung

Die Aufgabe der vorliegenden Erfindung besteht daher in der Bereitstellung einer Vorrichtung und eines Verfahrens, mit denen die Slurry zumindest teilweise aus den Zwischenräumen benachbarter dünner Scheiben automatisch entfernt werden kann.

### Lösung der Aufgabe

Der Kerngedanke der Erfindung ist es, eine Vorrichtung und ein Verfahren vorzuschlagen, mit denen der in unterschiedliche Verfahrensschritte gegliederte Reinigungsprozess selbsttätig (automatisch) durchlaufen wird.

Die erfindungsgemäße Vorrichtung ist Gegenstand des Anspruchs 1, während das erfindungsgemäße Verfahren durch die Merkmale des Anspruchs 11 definiert wird. Bevorzugte Ausführungsformen sind Gegenstand jeweiliger Unteransprüche.

### Vorteile der Erfindung

Um ein weitgehendes Entfernen der Slurry aus den Zwischenräumen zu ermöglichen, wird eine Vorrichtung zum Reinigen von bruchempfindlichen Wafern vorgeschlagen, wobei die Wafer mit ihrer einen Seite an einer Trägereinrichtung fixiert sind und jeweils zwischen zwei benachbarten Wafern ein Zwischenraum ausgebildet ist. Die erfindungsgemäße Vorrichtung besteht aus einer Duscheinrichtung, mit der Fluid in die jeweiligen Zwischenräume eingebracht wird, sowie einem Becken, das mit Fluid befüllbar und derart bemessen ist, dass es die Trägereinrichtung aufnimmt.

Die Trägereinrichtung, die mindestens aus dem Trägermaterial besteht, auf dem der Substratblock aufgebracht ist, umfasst die durch Sägen des Substratblocks erzeugten dünnen Scheiben (wie bspw. Wafer). Diese sind sequenziell, d.h. nacheinander aufgereiht, wobei zwischen den einzelnen Wafern jeweils ein Zwischenraum ausgebildet ist.

Die Duscheinrichtung umfasst mindestens ein eine Mehrzahl von Düsen aufweisendes Duschelement, welches zweiteilig ausgestaltet ist, wobei jeweils ein Teil seitlich an einer Längsseite des Beckens derart angeordnet ist, dass beide Teile parallel zur Längsachse des Beckens verlaufen und hinsichtlich ihrer Strömungsrichtung gegenständig positioniert sind. Erfindungsgemäß sind die beiden Teile des mindestens einen Duschelementes mittels einer alternierenden Steuerung derart steuerbar, dass direkt gegenüber liegende Düsen nicht gleichzeitig aktiviert werden. Die Duscheinrichtung ist derart ausgestaltet, dass sie vorzugsweise über die gesamte Längserstreckung der Wafer einen Fluidstrom überwiegend in die Zwischenräume erzeugt.

Der gesamte Reinigungsprozess ist in einem mit Fluid befüllbaren Becken vorgesehen. Das Becken ist derart bemessen, dass die Trägereinrichtung vollständig darin Platz findet.

Während des Duschvorgangs ist das Becken nicht gefüllt. Es dient vielmehr dazu, das durch die Wafer strömende Fluid zu sammeln und abzuführen. Nach einer bevorzugten Ausführungsform erfolgt der Duschvorgang in einem Becken, dessen Füllstand derart eingestellt wird, dass sich der untere Teil des Substratblocks (10 bis 50%, besonders bevorzugt ca. 30% der Waferfläche) in der Flüssigkeit befindet.

Die Ausgangslage des Reinigungsprozesses ist derart bestimmt, dass die Trägereinrichtung in eine "korbartige" Hilfseinrichtung der erfindungsgemäßen Vorrichtung übergeben wird. Die Ausgestaltung dieser Hilfseinrichtung ist grundsätzlich nicht festgelegt, solange gewährleistet ist, dass das Fluid die Zwischenräume zwischen den Wafern im Wesentlichen ungehindert erreichen kann und der Substratblock sowie gegebenenfalls abgelöste Wafer sicher gehalten werden. Nach einer bevorzugten Ausführungsform wird diese Einrichtung in Form zweier parallel zueinander in Längsrichtung verlaufender Stangenpaare bereitgestellt, wobei ein Paar als Auflage dient und ein weiteres Paar die Wafer seitlich stützt. Sobald die Hilfseinrichtung in die Vorrichtung eingebracht ist, ist das kammartige Gebilde des auf der Trägereinrichtung fixierten Substratblocks derart ausgerichtet, dass die Zwischenräume sowohl zu den Seitenwänden als auch zum Boden des Beckens offen und damit frei zugänglich sind. In dieser Ausgangslage befindet sich die Trägereinrichtung oberhalb der von ihr getragenen Substrate.

Erfindungsgemäß wird die Trägereinrichtung mit den Wafern also zunächst in das leere oder teilgefüllte Becken eingeführt.

Dem nachfolgend dargelegten weiteren Schritt des erfindungsgemäßen Reinigungsprozesses kann vorteilhafterweise eine Glykolvorlagerung der zu behandelnden Substrate vorgeschaltet sein.

Für den weiteren Schritt des erfindungsgemäßen Reinigungsprozesses ist nun vorgesehen, die Duscheinrichung zu aktivieren. Die Duscheinrichtung ist derart ausgebildet, dass der Fluidstrom in die jeweiligen Zwischenräume zweier benachbarter Wafer gerichtet ist und die verunreinigungen wegschwemmt. Erfindungsgemäß wird der Reinigungsprozess mit der Duscheinrichtung derart durchgeführt, dass direkt gegenüber liegende Düsen des mindestens einen Duschelementes nicht gleichzeitig aktiviert werden.

Das mindestens eine Duschelement bzw. ein Teil des zweiteiligen Duschelementes verfügt über eine Mehrzahl von Düsen (Öffnungen oder Bohrungen), die nach einer bevorzugten Ausführungsform funktionell über mindestens eine Düsenleiste miteinander in Verbindung stehen und somit von demselben Flüssigkeitsvolumen gespeist werden können. In Abhängigkeit der Länge des zu bearbeitenden Substratblockes und des zur Verfügung stehenden Förderdruckes kann das Duschelement beidseitig in mehrere Segmente unterteilt sein, die ihrerseits durch das Vorhandensein jeweils einer Düsenleiste gekennzeichnet sind. Die Position beider Teile des Duschelementes ist, gegebenenfalls getrennt voneinander, verstellbar. Sowohl die Höhe als auch der Abstand des Duschelementes oder eines seiner Teile oder Segmente vom Beckenrand ist veränderbar. Ferner kann das Duschelement oder eines seiner Teile oder Segmente parallel zum seitlichen Beckenrand verfahren werden. Gewünschten-falls kann die mindestens eine an einer Seite des Beckens angeordnete Düsenleiste eine oszillierende Bewegung ausführen, die wahlweise nach oben bzw. unten, vom Beckenrand weg bzw. zu ihm hin, und/oder parallel zum Beckenrand vor bzw. zurück gerichtet ist. Hierdurch können vorteilhafterweise eventuell vorhandene Inhomogenitäten in der Strömungscharakteristik ausgeglichen werden. Ein weiterer Vorteil der Oszillation parallel zur Achse der Düsenleiste liegt in der Vermeidung abweichender Strömungsverhältnisse, wie sie z.B. durch Verstopfung einzelner Düsen auftreten können. Durch diese Bewegungen werden zudem extrem aneinander haftende Substratverbände in Schwingung versetzt, wodurch die Reinigung der Zwischenräume derartiger Verbände verbessert wird. Sofern erfindungsgemäß mehrere Duschelemente vorhanden sind oder eingesetzt werden, sind diese in Bezug auf die Tiefe des Beckens auf unterschiedlichen Niveaus angeordnet.

Die Düsenleiste ist vorzugsweise rechteckig ausgestaltet, wobei die zum gegenüberliegenden Beckenrand weisende Seite in seinem oberen und/oder unteren Bereich besonders bevorzugt nach hinten abgeschrägt ist, wodurch die in den abgeschrägten Bereichen angeordneten Düsen leicht nach oben bzw. unten ausgerichtet sind und folglich nicht parallel zu den im mittleren Abschnitt angeordneten Düsen ausgeben können. Durch die abgeschrägten Bereiche wird bewirkt, dass Schmutzstellen zwischen zwei benachbarten Substraten noch wirksamer entfernt werden können. Vorzugsweise weisen die Düsenleisten jeweils mindestens einen Strombrecher auf, durch welche eine möglichst homogene Strömungscharakteristik über die gesamte Düsenleiste erreicht wird.

Die Düsenbohrungen sind vorzugsweise nicht kreisrund, sondern eher oval oder am meisten bevorzugt sternförmig, und weisen eine bevorzugte Querschnittsfläche von 0,1 bis 0,5, am meisten bevorzugt von 0,2 mm² auf, wobei sie bevorzugt derart kegelförmig ausgestaltet sind, dass der Durchmesser an der Austrittsseite um ca. 0,3 mm kleiner als derjenige an der Eintrittsseite ist. Die Geometrie der Düsenbohrungen ermöglicht vorzugsweise den Eintrag von Gas in den Flüssigkeitsstrom, wodurch positive Auswirkungen auf das Reinigungsergebnis erzielt werden können. Vorzugsweise sind die Düsen in einer jeweiligen Düsenleiste in Spalten und Zeilen angeordnet, wobei die Spalten bevorzugt 4 mm und die Zeilen bevorzugt 3 mm voneinander beabstandet sind. Am meisten bevorzugt ist die Geometrie der Düsen derart ausgestaltet, dass ein möglichst weit reichender (z.B. 400 mm) Flüssigkeitsstrahl entsteht, der einen bevorzugten Durchmesser von ca. 1 mm aufweist und auch bei kleinen Strömungsgeschwindigkeiten turbulent ist. Auf diese Weise ist der Strahl in seiner Wirkung auf dem Objekt "weich".

Nach einer bevorzugten Ausführungsform werden die beidseitig vorhandenen Düsenleisten des mindestens einen Duschelementes der Duscheinrichtung so gesteuert, dass die Flüssigkeit lediglich auf einer Seite ausgegeben wird, während die Düsen auf der anderen Seite keine Flüssigkeit ausgeben. Nach kurzer Behandlungsdauer werden die Seiten gewechselt, sodass die Flüssigkeit alternierend von links bzw. rechts auf den Substratblock gerichtet wird. Sofern ein Teil des erfindungsgemäßen Duschelementes (eine Seite) mehrere Segmente mit jeweils einer Düsenleiste umfasst, ist auch hier sicherzustellen, dass direkt gegenüber liegende Düsen nicht gleichzeitig aktiviert werden. Dem Fachmann ist klar, dass dies auf verschiedene Art und Weise ausgeführt werden kann. Beispielsweise werden alle Düsen sämtlicher vorhandener Düsenleisten auf einer Seite aktiviert, während die Gesamtheit der Düsen auf der gegenüberliegenden Seite nicht aktiviert wird. Alternativ werden die Düsen bzw. Düsenleisten seitlich benachbarter Segmente derart gesteuert, dass direkt benachbarte Segmente nicht gleichzeitig aktiviert werden, wobei auch hier mit Blick auf beide Seiten gilt, dass direkt gegenüber liegende Düsen bzw. Düsenleisten oder Segmente nicht gleichzeitig aktiviert werden. Durch diese alternierende Steuerung wird erreicht, dass die Abreinigung optimal verläuft.

Ferner sind Mittel vorgesehen, die ein Fluid zu dem mindestens einen Duschelement transportieren. Für den Reinigungsprozess sind als Prozessparameter u.a. die Menge an Fluid (bzw. Flüssigkeit) und dessen Stömungsgeschwindigkeit bestimmend. Beide Parameter können über geeignete bekannte Mittel variiert werden. Erfindungsgemäß kann der Druck des Fluids an der Gesamtheit der Austrittsöffnungen eines Duschelements auf einen Wert zwischen 0,1 und 1,0 bar, vorzugsweise auf einen Wert zwischen 0,2 und 0,5 bar eingestellt werden.

Vorzugsweise zusätzlich zu den vorbeschriebenen Bewegungen des mindestens einen Duschelementes oder eines seiner Teile oder Segmente wird nun für den Reinigungsprozess, nämlich für das Entfernen der Slurry aus den Zwischenräumen, wahlweise entweder die Duscheinrichtung relativ zur feststehenden Trägereinrichtung oder die Trägereinrichtung relativ zur feststehenden Duscheinrichtung bewegt. Alternativ kann auch vorgesehen werden, dass sowohl die Trägereinrichtung als auch die Duscheinrichtung relativ zueinander bewegt werden.

Damit ein Durchfließen des Fluidstroms durch die Zwischenräume möglich ist, wird die Trägereinrichtung derart positioniert, dass die jeweils offenen Seiten zu den beiden Seitenwänden des Beckens und in Richtung des Bodens des Beckens weisen. Durch die alternierende, d.h. wechselseitige Aktivierung der erfindungsgemäßen Duscheinrichtung wird erreicht, dass die Slurry sowohl von der einen als auch von der anderen Seite aus den Zwischenräumen gespült wird.

Durch einen erhöhten Volumenstrom des Fluids ergibt sich weiterhin der Vorteil, dass die an den freien Enden zusammenklebenden Wafer in einem Abstand zueinander gehalten werden.

Ein weiterer Vorteil eines hohen Volumenstroms besteht darin, dass die Wafer zumindest geringfügig vibrieren, so dass sich die an der Oberfläche eines Wafers anhaftende Slurry einfacher lösen kann.

Zur Optimierung des Reinigungsprozesses ist optional mindestens eine Ultraschalleinrichtung vorgesehen, die innerhalb des Beckens wahlweise stationär oder bewegbar angeordnet ist. Die Ultraschallquellen können ferner schräg oder parallel zu den Wafern ausgerichtet bzw. angeordnet sein. Dieser optionale Reinigungsprozess schließt sich vorteilhafterweise unmittelbar an den Reinigungsprozess mit dem mindestens einen Duschelement an. Für die Durchführung dieses Prozesses ist es notwendig, dass das Becken, in dem die Trägereinrichtung angeordnet ist, mit Fluid gefüllt wird. Vorzugsweise wird ein kaltes Fluid verwendet, um eine optimale Übertragung der Ultraschallwellen zu ermöglichen. Vorzugsweise wird die Temperatur auf einen Wert zwischen 15 und 25 °C eingestellt, um chemische Reaktionen zu unterbinden und eine im Wesentlichen mechanische Behandlung zu gewährleisten.

Der Reinigungsprozess mit Ultraschallwellen kann vorzugsweise durch mindestens eine stationäre oder verfahrbare Querströmungseinrichtung zur Erzeugung eines Fluidstroms innerhalb des Beckens unterstützt werden, wobei die zuvor beschriebene Duscheinrichtung mit ihrem mindestens einen Duschelement die Funktion dieser Querströmungseinrichtung ausübt. Demnach ist die Querströmungseinrichtung derart ausgebildet, dass der Fluidstrom in die jeweiligen Zwischenräume zweier benachbarter Wafer gerichtet ist und die durch den Ultraschall herausgelösten Teilchen wegschwemmt. Die mindestens eine Querströmungseinrichtung bzw. ein Teil der zweiteiligen Einrichtung verfügt über eine Mehrzahl von Düsen (Öffnungen oder Bohrungen), die funktionell über mindestens eine Düsenleiste miteinander in Verbindung stehen und somit von demselben Flüssigkeitsvolumen gespeist werden können. In Abhängigkeit der Länge des zu bearbeitenden Substratblockes und des zur Verfügung stehenden Förderdruckes kann die Querströmungseinrichtung beidseitig in mehrere Segmente unterteilt sein, die ihrerseits durch das Vorhandensein jeweils einer Düsenleiste gekennzeichnet sind. Die Position beider Teile der Querströmungseinrichtung ist, gegebenenfalls getrennt voneinander, verstellbar. Sowohl die Höhe als auch der Abstand der Querströmungseinrichtung oder eines seiner Teile oder Segmente vom Beckenrand ist veränderbar. Ferner kann die Querströmungseinrichtung oder eines seiner Teile oder Segmente parallel zum seitlichen Beckenrand verfahren werden. Die Querströmungseinrichtung wird vorzugsweise nur aktiviert, wenn sich ihre Düsen unterhalb des Pegelstandes der Flüssigkeit befinden. Gewünschtenfalls kann die mindestens eine an einer Seite des Beckens angeordnete Düsenleiste eine oszillierende Bewegung ausführen, die wahlweise nach oben bzw. unten, vom Beckenrand weg bzw. zu ihm hin, und/oder parallel zum Beckenrand vor bzw. zurück gerichtet ist. Hierdurch können vorteilhafterweise ortsunabhängige Flüssigkeitswirbel entstehen und genutzt werden. Ein weiterer Vorteil der Oszillation parallel zur Achse der Düsenleiste liegt in der Vermeidung abweichender Strömungsverhältnisse, wie sie z.B. durch Verstopfung einzelner Düsen auftreten können. Durch diese Bewegung werden zudem extrem aneinander haftende Substratverbände in Schwingung versetzt, wodurch die Reinigung der Zwischenräume derartiger Verbände verbessert wird. Sofern erfindungsgemäß mehrere Querströmungseinrichtungen vorhanden sind oder eingesetzt werden, sind diese in Bezug auf die Tiefe des Beckens auf unterschiedlichen Niveaus angeordnet.

Die Düsenleiste ist vorzugsweise rechteckig ausgestaltet, wobei die zum gegenüberliegenden Beckenrand weisende Seite in seinem oberen und/oder unteren Bereich besonders bevorzugt nach hinten abgeschrägt ist, wodurch die in den abgeschrägten Bereichen angeordneten Düsen leicht nach oben bzw. unten ausgerichtet sind und folglich nicht parallel zu den im mittleren Abschnitt angeordneten Düsen ausgeben können. Durch die abgeschrägten Bereiche wird bewirkt, dass Schmutzstellen zwischen zwei benachbarten Substraten noch wirksamer entfernt werden können. Vorzugsweise weisen die Düsenleisten Strombrecher auf, durch welche eine möglichst homogene Strömungscharakteristik über die gesamte Düsenleiste erreicht wird.

Die Düsenbohrungen sind vorzugsweise nicht kreisrund, sondern eher oval oder am meisten bevorzugt sternförmig, und weisen eine bevorzugte Querschnittsfläche von 0,1 bis 0,5, am meisten bevorzugt von 0,2 mm² auf, wobei sie bevorzugt derart kegelförmig ausgestaltet sind, dass der Durchmesser an der Austrittsseite um ca. 0,3 mm kleiner als derjenige an der Eintrittsseite ist. Die Geometrie der Düsenbohrungen ermöglicht vorzugsweise den Eintrag von Gas in den Flüssigkeitsstrom, wodurch positive Auswirkungen auf das Reinigungsergebnis erzielt werden können. Vorzugsweise sind die Düsen in einer jeweiligen Düsenleiste in Spalten und Zeilen angeordnet, wobei die Spalten bevorzugt 4 mm und die Zeilen bevorzugt 3 mm voneinander beabstandet sind. Am meisten bevorzugt ist die Geometrie der Düsen derart ausgestaltet, dass ein möglichst weit reichender (z.B. 400 mm) Flüssigkeitsstrahl mit einem bevorzugten Durchmesser von ca. 1 mm entsteht, der auch bei kleinen Strömungsgeschwindigkeiten turbulent ist. Auf diese Weise ist der Strahl in seiner Wirkung auf dem Objekt "weich".

Nach einer bevorzugten Ausführungsform werden die beidseitig vorhandenen Düsenleisten der Querströmungseinrichtung so gesteuert, dass die Flüssigkeit lediglich auf einer Seite ausgegeben wird, während die Düsen auf der anderen Seite keine Flüssigkeit ausgeben. Nach kurzer Behandlungsdauer werden die Seiten gewechselt, sodass die Flüssigkeit alternierend von links bzw. rechts auf den Substratblock gerichtet wird. Sofern ein Teil der Querströmungseinrichtung (eine Seite) mehrere Segmente mit jeweils einer Düsenleiste umfasst, ist vorzugsweise auch hier sicherzustellen, dass direkt gegenüber liegende Düsen nicht gleichzeitig aktiviert werden. Durch diese alternierende Steuerung wird erreicht, dass die Abreinigung optimal verläuft.

Nach der Ultraschallbehandlung des Substratblocks wird das Becken entleert, und ein weiterer Reinigungsprozess mit dem mindestens einen Duschelement beginnt. Der Prozess kann je nach Bedarf wiederholt werden, indem sich die Zyklen "Reinigungsprozess mit Duschelement" und "Reinigungsprozess mit Ultraschall" entsprechend abwechseln.

Eine besondere Ausbildung der Erfindung sieht vor, dass der Substratblock zunächst unter Verwendung der Duscheinrichtung mit einem warmen, gewünschtenfalls geeignete chemische Zusätze wie z.B. Tenside enthaltenden Fluid gereinigt wird, wobei dessen Temperatur vorzugsweise zwischen 35 und 40°C beträgt. Anschließend findet die Ultraschallreinigung innerhalb eines kalten Fluids statt. Beide Prozesse wiederholen sich gegebenenfalls. Als letzter Prozess ist ein Reinigungsprozess unter Verwendung der Duscheinrichtung mit einem kalten Fluid vorgesehen. Letzteres bringt den Vorteil mit sich, dass durch das Duschen mit einem kalten Fluid verhindert wird, dass die Wafer "austrocknen" und so eventuell übrig gebliebene Slurry fest an den Wafern anhaftet.

Das Duschfluid ist erfindungsgemäß wässrig und wird vorzugsweise auf eine Temperatur zwischen 15 und 40°C eingestellt, wobei eine Temperatur zwischen 30 und 40°C besonders bevorzugt ist. Vorzugsweise umfasst es geeignete nicht-schäumende, nicht-ionische Tenside in einer Menge von 0 bis 1 Vol.%, wobei eine Menge von 0,1 bis 0,5 Vol.%, bezogen auf die gesamte Fluidmenge, besonders bevorzugt ist. Vorzugsweise weist das bzw. weisen die Tenside einen (gemittelten) pH-Wert von etwa 13,0 auf, wodurch der pH-Wert des Duschfluids vorteilhaft auf einen bevorzugten Wert kleiner 12,0, besonders bevorzugt auf einen Wert zwischen 10,5 und 11,0 eingestellt werden kann. Ferner kann das Duschfluid Lauge oder Säure sowie gewünschten-falls weitere Chemikalien umfassen.

Gewünschtenfalls kann das erfindungsgemäße Verfahren in einer bevorzugten Ausführungsform noch einen weiteren Verfahrensschritt der Kleberablösung umfassen. Hierzu wird die Trägereinrichtung ggfs. mit der Hilfseinrichtung in ein Behandlungsbecken überführt, welches eine in Abhängigkeit von der Beschaffenheit des verwendeten Klebers geeignete Flüssigkeit beinhaltet. Als besonders geeignet hat sich beispielsweise die Verwendung einer Essigsäure enthaltenden wässrigen Flüssigkeit erwiesen, deren Temperatur und pH-Wert besonders bevorzugt auf Werte um 40°C bzw. 3,0 bis 4,0 eingestellt sind. Anschließend werden die Wafer gespült, was vorzugsweise dadurch erfolgt, dass sie mit der Hilfseinrichtung in ein mit Wasser gefülltes Spülbecken überführt werden.

Ein weiterer wesentlicher Vorteil des Verfahrens ist, dass es sich in einen nachfolgenden Bearbeitungsprozess der Wafer einfach eingliedern lässt. Besonders vorteilhaft hat sich herausgestellt, dass die Prozessparameter erfindungsgemäß genau und reproduzierbar eingestellt werden können, wodurch die Behandlung auch größerer Stückzahlen auf gleichem Qualitätsniveau ermöglicht wird.

Weitere vorteilhafte Ausgestaltungen gehen aus der nachfolgenden Beschreibung sowie den Zeichnungen und den Ansprüchen hervor.

### Zeichnungen

Es zeigen:
- Fig. 1: eine schematische Ansicht der Trägerein- richtung 2, im Wesentlichen bestehend aus dem zu reinigenden Substratblock 1;
- Fig. 2: eine perspektivische Ansicht einer Hilfsein- richtung 8 zur Aufnahme der Trägerein- richtung 2 gemäß Fig. 1;
- Fig. 3: eine perspektivische Ansicht einer Hilfsein- richtung 8, gegenüber Fig. 2 mit der bereits aufgenommenen Trägereinrichtung 2;
- Fig. 4: eine schematische Ansicht der erfindungs- gemäßen Vorrichtung mit Duscheinrichtung in Form eines zweiteiligen Duschelementes 16;
- Fig. 5: eine schematische Ansicht der Vorrichtung mit Duschelement 16 bzw. Querströmungs- einrichtung 17, jedoch gegenüber Fig. 4 bereits mit eingefügter Trägereinrichtung in Ausgangslage (A); eine schematische Ansicht mit genauerer Darstellung von Ultraschall- einrichtung 18 und beidseitig angeordnetem Duschelement 16 bzw. beidseitig angeordneter Querströmungseinrichtung 17 (B).

### Beschreibung eines Ausführungsbeispiels

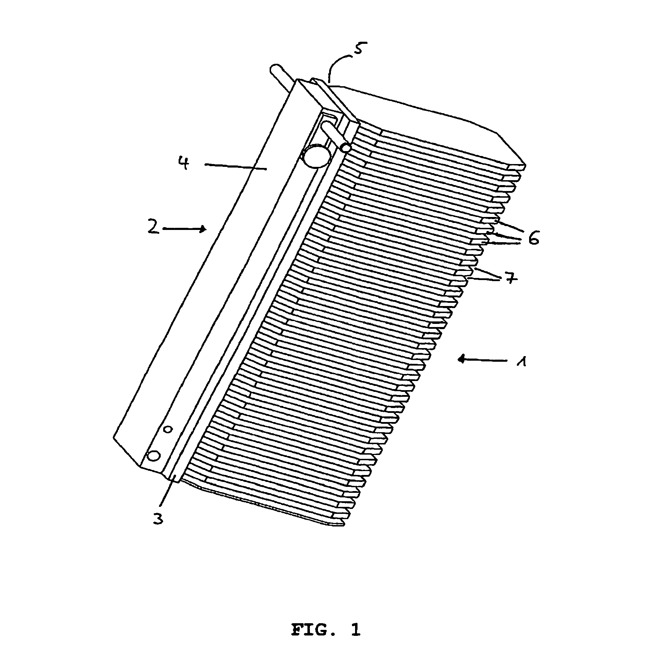

In Fig. 1 ist ein zu reinigender Substratblock 1 dargestellt. Der Substratblock 1 ist auf einer Trägereinrichtung 2 aufgebracht, die aus einer Glasplatte 3 sowie einem Befestigungselement 4 besteht. Der Substratblock 1 ist bei dem hier dargestellten Ausführungsbeispiel mit seiner einen Seite 5 flächig auf der Glasplatte 3 aufgeklebt. Durch den bereits durchgeführten Sägeprozess, dessen Schnitte bis in die Glasplatte 3 hineinreichen, entstehen einzelne Substrate, die auch als Wafer 6 bezeichnet werden. Zwischen den einzelnen Wafern 6 entsteht jeweils ein Zwischenraum 7, in dem sich die sogenannte Slurry (in den Zeichnungen nicht dargestellt) befindet, die durch den erfindungsgemäßen Reinigungsprozess entfernt werden soll.

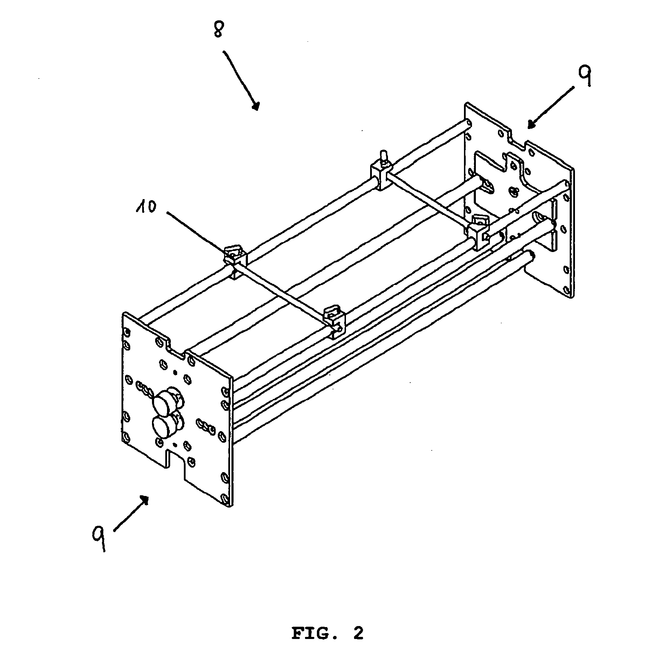

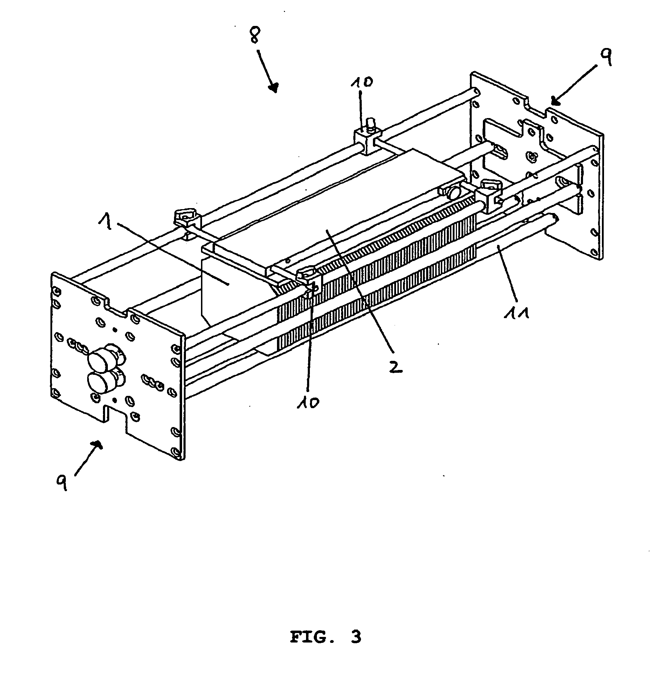

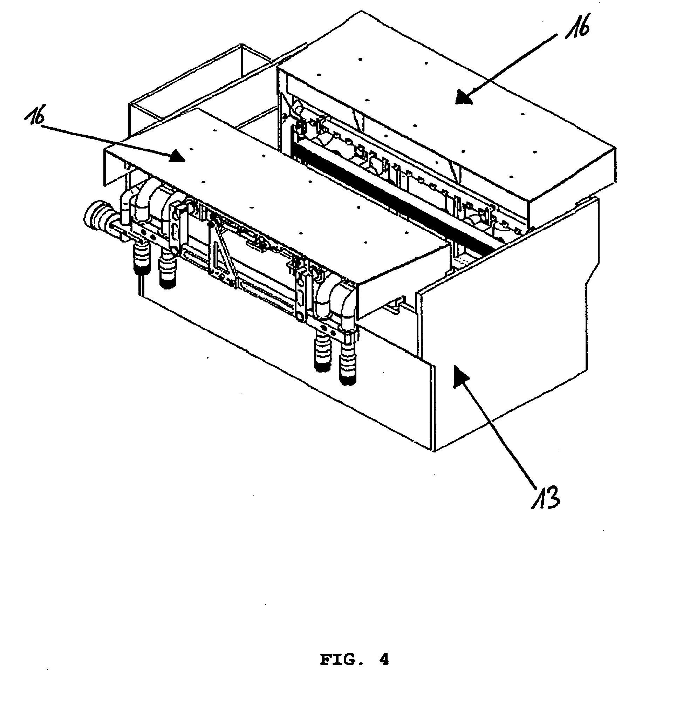

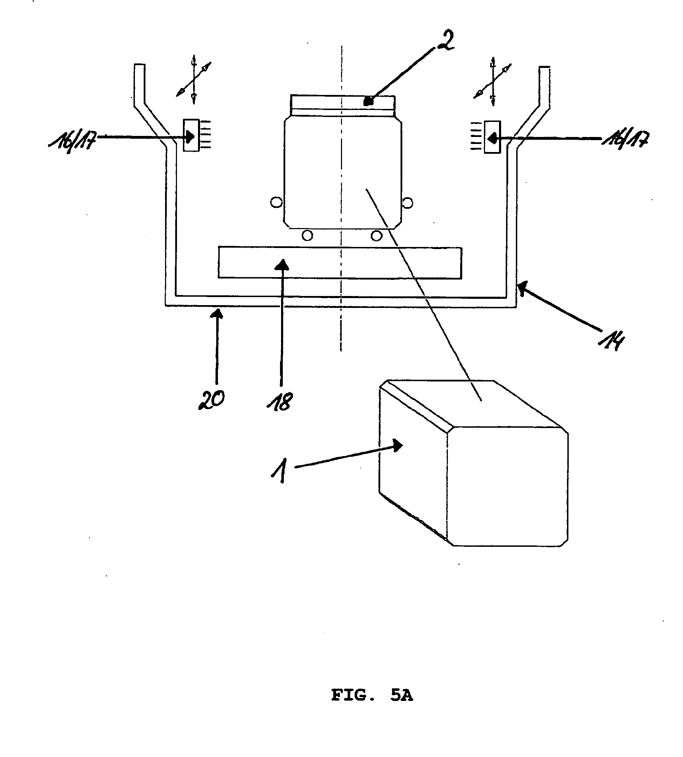

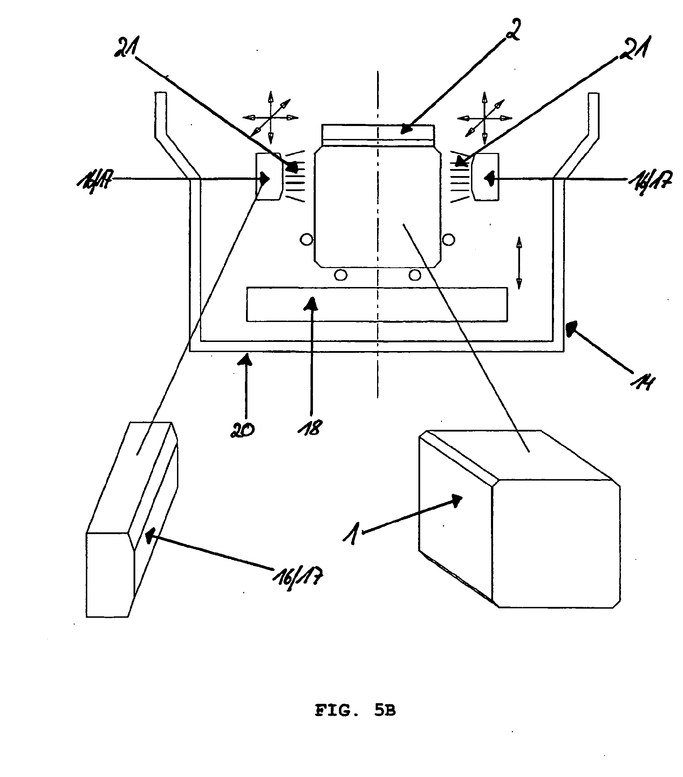

Um den mit der Trägereinrichtung 2 verbundenen Substratblock 1 an die erfindungsgemäße Vorrichtung, wie sie in den Fig. 4 und 5 dargestellt ist, übergeben zu können, wird die Trägereinrichtung 2 mit einer Hilfseinrichtung 8, wie sie in Fig. 2 und 3 dargestellt ist, übergeben. Vorzugsweise umfasst die Hilfseinrichtung 8 seitlich angeordnete Mittel 9, die mit der Vorrichtung gemäß den Fig. 4 und 5 zusammenwirken. Um unterschiedlich große Trägereinrichtungen 2 aufnehmen zu können, ist vorgesehen, eine Aufnahmeeinrichtung 10 bereitzustellen, die flexibel in ihrer Lage zur Aufnahme der Trägereinrichtung 2 positionierbar ist. Zudem ist die Hilfseinrichtung 8 derart gestaltet, dass der Substratblock 1 gemäß Darstellung in Fig. 3 eine geschützte Lage gegen ungewolltes Anstoßen an einen Gegenstand einnimmt. Bei dem hier dargestellten Ausführungsbeispiel sind Stangen 11 als Verbindungselemente zwischen den vorgesehenen Mitteln 9 angeordnet, die den Substratblock 1 zwischen sich einschließen.

Um den Reinigungsprozess durchzuführen, ist die Vorrichtung 12 gemäß Darstellung in Fig. 5 mit der Hilfseinrichtung 8 zu beladen. Die Vorrichtung 12 selbst zeigt ein Gehäuse 13, das ein mit einem Fluid befüllbares Becken 14 umfasst. Das Becken 14 ist derart bemessen, dass die Hilfseinrichtung 8 vollständig von dem Becken 14 aufgenommen werden kann.

Das Becken 14 ist vorzugsweise derart ausgestaltet, dass es die Hilfseinrichtung 8 an den entsprechenden Mitteln 9 aufnehmen kann.

Ferner weist die Vorrichtung 12 eine Duscheinrichtung 15 auf. Die Duscheinrichtung 15 besteht aus einem Duschelement 16, das zweiteilig ausgebildet ist und sich parallel zur Längserstreckung der Trägereinrichtung 2 erstreckt.

Bei dem in Fig. 5 dargestellten Ausführungsbeispiel wird das Duschelement während der Ultraschallbehandlung als Querströmungseinrichtung 17 eingesetzt. Diese folglich ebenfalls zweiteilig ausgebildete Querströmungseinrichtung weist düsenartige Ausbildungen auf, die innerhalb des Beckens 14 zur Reinigung des Substratblocks 1 eine Querströmung erzeugen.

Ferner ist auf der Bodenseite des Gehäuses 13 eine Ultraschalleinrichtung 18 mit Ultraschallquellen 19 vorgesehen. Diese Ultraschalleinrichtung 18 wird je nach Bedarf zu- oder abgeschaltet und dient dazu, zusätzlich die in den Zwischenräumen 7 befindliche Slurry aufzulockern bzw. zu entfernen.

Alternativ zu der in Fig. 5 dargestellten Ultraschalleinrichtung 18 kann vorgesehen werden, dass anstelle des stationären festen Einbaus eine mobile Ultraschalleinrichtung vorgesehen ist, die auch innerhalb des Beckens 14 in beliebiger Stellung verfahrbar ist.

### Funktionsweise:

Der Reinigungsprozess gestaltet sich wie folgt:
Nachdem die Trägereinrichtung 2 zusammen mit der Hilfseinrichtung 8 in die Vorrichtung 12 eingebracht worden ist (Fig. 5), nimmt die Trägereinrichtung 2 eine Stellung ein, durch die die einzelnen. Wafer 6 in Richtung des Bodens 20 gerichtet sind. Dies bedeutet, dass die Zwischenräume 7 jeweils zu den Seiten und in Richtung Boden 20 des Beckens 14 offen sind.

Der Reinigungsprozess beginnt, indem die Duscheinrichtung 15 aktiviert wird. Der aus dem Duschelement 16 austretende Fluidstrom 21 gelangt in die jeweiligen Zwischenräume 7, fließt durch diese zumindest teilweise hindurch, um dann in Richtung Boden 20 des Beckens 14 wieder auszutreten. Durch die zuvor detailliert dargelegte erfindungsgemäße Vorgehensweise kann die Slurry aus den jeweiligen Zwischenräumen 7 entfernt werden. Je nach Verschmutzungsgrad kann dieser Reinigungsprozess beliebig oft wiederholt werden. Der Fluidstrom 21 selbst ist vorzugsweise temperiert und kann Temperaturen zwischen 25 Grad und 40 Grad Celsius aufweisen.

Anschließend findet nach einer bevorzugten Ausführungsform eine Ultraschallreinigung mit der Ultraschalleinrichtung 18 statt. Hierzu ist es notwendig, dass das Becken 14 zur Übertragung der Schallwellen von den Ultraschallquellen mit einem Fluid gefüllt wird.

Im Anschluss hieran wird das Becken 14 entleert und der bereits beschriebene Duschvorgang beginnt.

Auf diese Weise können sich die einzelnen Schritte beliebig wiederholen.

Vor der Entnahme des dann vorgereinigten (precleaned) Substratblocks 1 findet vorzugsweise nochmals ein Duschvorgang statt, jedoch mit einem kalten Fluid. Dadurch kann verhindert werden, dass noch vorhandene Slurry zumindest unmittelbar antrocknet.

Durch die erfindungsgemäße Vorrichtung 1 und das Anwenden des erfindungsgemäßen Verfahrens ist es möglich geworden, dünne, bruchempfindliche Scheiben selbsttätig (automatisch) vorzureinigen. Insbesondere bei der Herstellung von Wafern für die Halbleiter- und Solarindustrie ist es notwendig, die sogenannte Slurry unmittelbar nach dem Sägeprozess zu entfernen. Diese Slurry haftet sehr stark an der Oberfläche des jeweiligen Wafers, weshalb bisher eine manuelle Behandlung durchgeführt werden musste. Durch das erfindungsgemäße Verfahren ist es jedoch möglich geworden, eine qualitativ sehr gute und automatisierte Vorreinigung der Wafer 6 zu ermöglichen.

Die vorliegende Erfindung wurde im Hinblick auf die Behandlung von Siliziumwafern dargelegt. Selbstverständlich können auch scheibenförmige Substrate aus anderen Materialien wie z.B. Kunststoff erfindungsgemäß bearbeitet werden.

### BEZUGSZEICHENLISTE

- 1.: Substratblock
- 2.: Trägereinrichtung
- 3.: Glasplatte
- 4.: Befestigungselement
- 5.: eine Seite
- 6.: Wafer
- 7.: Zwischenraum
- 8.: Hilfseinrichtung
- 9.: Mittel
- 10.: Aufnahmeeinrichtung
- 11.: Stangen
- 12.: Vorrichtung
- 13.: Gehäuse
- 14.: Becken
- 15.: Duscheinrichtung
- 16.: Duschelement
- 17.: Querströmungseinrichtung
- 18.: Ultraschalleinrichtung
- 19.: Ultraschallquellen
- 20.: Boden
- 21.: Fluidstrom

## Patentansprüche

1. Vorrichtung zum Reinigen von bruchempfindlichen Wafern (6), wobei die Wafer (6) mit ihrer einen Seite an einer Trägereinrichtung (2) fixiert sind und jeweils zwischen zwei benachbarten Wafern ein Zwischenraum (7) ausgebildet ist, bestehend aus:
- einem Becken (14), das mit Fluid befüllbar ist und derart bemessen ist, dass es die Trägereinrichtung (2) aufnimmt,
- einer Duscheinrichtung (15), mit der Fluid in die jeweiligen Zwischenräume (7) eingebracht wird, mit mindestens einem eine Mehrzahl von Düsen aufweisenden Duschelement (16), welches zweiteilig ausgestaltet ist, wobei jeweils ein Teil seitlich an einer Längsseite des Beckens (14) derart angeordnet ist, dass beide Teile parallel zur Längsachse des Beckens verlaufen und hinsichtlich ihrer Strömungsrichtung gegenständig positioniert sind, sowie
**dadurch gekennzeichnet, dass** die beiden Teile des mindestens einen Duschelementes (16) mittels einer alternierenden Steuerung derart steuerbar sind, dass direkt gegenüber liegende Düsen nicht gleichzeitig aktiviert werden.

2. Vorrichtung nach Anspruch 1, **dadurch gekennzeichnet, dass** die Düsen funktionell über mindestens eine Düsenleiste miteinander in Verbindung stehen und somit von demselben Flüssigkeitsvolumen gespeist werden können.

3. Vorrichtung nach Anspruch 1 oder 2, **dadurch gekennzeichnet, dass** das mindestens eine Duschelement (16) beidseitig in mehrere Segmente unterteilt ist, die jeweils eine Düsenleiste aufweisen.

4. Vorrichtung nach einem der Ansprüche 1 bis 3, **dadurch gekennzeichnet, dass** die Position beider Teile des Duschelementes (16), gegebenenfalls getrennt voneinander, verstellbar ist.

5. Vorrichtung nach einem der vorhergehenden Ansprüche, **dadurch gekennzeichnet, dass** wahlweise entweder die Duscheinrichtung (15) relativ zur feststehenden Trägereinrichtung (2), oder die Trägereinrichtung (2) relativ zur feststehenden Duscheinrichtung (15), oder sowohl die Trägereinrichtung (2) als auch die Duscheinrichtung (15) relativ zueinander bewegbar sind.

6. Vorrichtung nach einem der vorhergehenden Ansprüche, **dadurch gekennzeichnet, dass** mindestens eine Ultraschalleinrichtung (18) vorgesehen ist, die innerhalb des Beckens (14) wahlweise stationär oder bewegbar angeordnet ist.

7. Vorrichtung nach einem der vorhergehenden Ansprüche, **dadurch gekennzeichnet, dass** mehrere Duschelemente (16) in Bezug auf die Tiefe des Beckens (14) auf unterschiedlichen Niveaus angeordnet sind.

8. Vorrichtung nach einem der vorhergehenden Ansprüche, **dadurch gekennzeichnet, dass** das mindestens eine Duschelement (16) innerhalb des Beckens (14) höhenverstellbar ist.

9. Vorrichtung nach einem der Ansprüche 6 bis 8, **dadurch gekennzeichnet, dass** die Ultraschalleinrichtung (18) Ultraschallquellen (19) umfasst, die schräg zur horizontalen Ausrichtung der Trägereinrichtung (2) angeordnet sind.

10. Vorrichtung nach einem der Ansprüche 6 bis 9, **dadurch gekennzeichnet, dass** die Ultraschallquellen (19) rotierend angeordnet sind.

11. Verfahren zum Reinigen von bruchempfindlichen Wafern (6) mittels einer Vorrichtung, wobei die Wafer (6) mit ihrer einen Seite an einer Trägereinrichtung (2) fixiert sind und jeweils zwischen zwei benachbarten Wafern ein Zwischenraum (7) ausgebildet ist, und wobei die Vorrichtung aus einer Duscheinrichtung (15), mit der Fluid in die jeweiligen Zwischenräume (7) eingebracht wird, sowie einem Becken (14) besteht, das mit Fluid befüllbar und derart bemessen ist, das es die Trägereinrichtung (2) aufnimmt, wobei die Duscheinrichtung (15) mindestens ein eine Mehrzahl von Düsen aufweisendes Duschelement (16) umfasst, welches zweiteilig ausgestaltet ist, wobei jeweils ein Teil seitlich an einer Längsseite des Beckens (14) derart angeordnet ist, dass beide Teile parallel zur Längsachse des Beckens verlaufen und hinsichtlich ihrer Strömungsrichtung gegenständig positioniert sind, **gekennzeichnet durch** folgende Verfahrensschritte:
a) Einführen der Trägereinrichtung (2) mit den Wafern (1) in das leere oder teilgefüllte Becken (14); und
b) Durchführen des Reinigungsprozesses mit der Duscheinrichtung (15), wobei direkt gegenüber liegende Düsen des mindestens einen Duschelementes (16) nicht gleichzeitig aktiviert werden.

12. Verfahren nach Anspruch 11, **dadurch gekennzeichnet, dass** es als zusätzlichen Verfahrensschritt c) das Durchführen des Reinigungsprozesses mit einer innerhalb des Beckens angeordneten Ultraschalleinrichtung (18) in Anwesenheit von Fluid umfasst.

13. Verfahren nach Anspruch 12, **dadurch gekennzeichnet, dass** der Verfahrensschritt b) vor und nach dem Verfahrensschritt c) durchgeführt wird.

14. Verfahren nach Anspruch 12, **dadurch gekennzeichnet, dass** die Verfahrensschritte b) und c) mehrmals nacheinander durchgeführt werden.

## Claims

1. Apparatus for the cleaning of fragile wafers (6), wherein the wafers (6) are fixed with one side to a carrier device (2), and wherein an interspace (7) is formed between two adjacent wafers, consisting of:
- a basin (14) that can be filled with fluid and that is dimensioned such that it houses the carrier device (2), as well as
- a shower device (15), by which fluid is injected into the respective interspaces (7), with at least one shower element (16) having a plurality of nozzles and a two-part design with each respective part being arranged laterally at one long side of the basin (14) in such a manner that both parts run parallel to the longitudinal axis of the basin and, with respect to their flow direction, are positioned in opposing directions,
**characterized in that** said both parts of the at least one shower element (16) are controllable by means of an alternating control in such a manner that directly opposing nozzles are not activated simultaneously.

2. Apparatus according to claim 1, **characterized in that** the nozzles are functionally connected to each other via at least one nozzle bar so that they can therefore be fed by the same fluid volume.

3. Apparatus according to claim 1 or 2, **characterized in that** the at least one shower element (16) is divided into several segments on both sides, wherein each of the segments has one nozzle bar.

4. Apparatus according to any of claims 1 to 3, **characterized in that** the position of both parts of the shower element (16) is adjustable, if necessary, separately from each other.

5. Apparatus according to any of the preceding claims, **characterized in that** either the shower device (15) can be moved in relation to the immobile carrier device (2), or the carrier device (2) can be moved in relation to the immobile shower device (15), or the carrier device (2) as well as the shower device (15) can be moved in relation to each other.

6. Apparatus according to any of the preceding claims, **characterized in that** at least one ultrasonic device (18) is provided that is arranged within the basin (14) optionally immobile or movable.

7. Apparatus according to any of the preceding claims, **characterized in that** several shower elements (16) are arranged on different levels with respect to the depth of the basin (14).

8. Apparatus according to any of the preceding claims, **characterized in that** the at least one shower element (16) is vertically adjustable within the basin (14).

9. Apparatus according to any of claims 6 to 8, **characterized in that** the ultrasonic device (18) comprises ultrasonic sources (19) that are arranged inclined to the horizontal orientation of the carrier device (2).

10. Apparatus according to any of claims 6 to 9, **characterized in that** the ultrasonic sources (19) are arranged rotating.

11. Method for the cleaning of fragile wafers (6) by means of an apparatus, wherein the wafers (6) are fixed with one side to a carrier device (2), and wherein an interspace (7) is formed between two adjacent wafers, and wherein the apparatus consists of a shower device (15) by which fluid is injected into the respective interspaces (7), as well as a basin (14) that can be filled with fluid and that is dimensioned such that it houses the carrier device (2), wherein the shower device (15) comprises at least one shower element (16) having a plurality of nozzles and a two-part design with each respective part being arranged laterally at one long side of the basin (14) in such a manner that both parts run parallel to the longitudinal axis of the basin and, with respect to their flow direction, are positioned in opposing directions, **characterized by** the following process steps:
a) insertion of the carrier device (2) with the wafers (1) into the empty or partly filled basin (14); and
b) carrying out of the cleaning process with the shower device (15), wherein directly opposing nozzles of the at least one shower element (16) are not activated simultaneously.

12. Method according to claim 11, **characterized in that** it comprises as an additional step c) the carrying out of the cleaning process with an ultrasonic device (18) being arranged within the basin in the presence of fluid.

13. Method according to claim 12, **characterized in that** the process step b) is carried out before and after the process step c).

14. Method according to claim 12, **characterized in that** the process steps b) and c) are carried out several times one after the other.

## Revendications

1. Dispositif pour le nettoyage des plaquettes cassables (6), les plaquettes (6) étant fixées par un de leurs cotés à un dispositif porteur (2) et un intervalle (7) étant formé entre chaque paire de plaquette voisines, constitué par:
- un bassin (14) qui peut être rempli de fluide et de dimensions telles qu'il intègre le dispositif de transport (2), ainsi que
- un dispositif de douche (15), grâce auquel fluide est injecté dans les intervalles (7), avec au moins un élément de douche (16) comprenant plusieurs gicleurs, lequel est conçu en deux parties, chaque partie étant localisée latéralement sur le grand coté du bassin (14) de telle manière que les deux parties sont parallèles à l'axe longitudinal du bassin et en opposition par rapport à la direction de leurs flux,
**caractérisé en ce que** les deux parties du, au moins, un élément de douche (16) sont contrôlables au moyen d'une commande alternée de telle manière que les gicleurs positionnés en vis-à-vis direct ne sont pas activés en même temps.

2. Dispositif selon la revendication 1, **caractérisé en ce que** les gicleurs sont connectés fonctionnellement les uns aux autres par au moins une barrette à gicleurs et ainsi peuvent être alimentés à partir du même volume de fluide.

3. Dispositif selon la revendication 1 ou 2, **caractérisé en ce que** le, au moins un, élément de douche (16) est divisé en plusieurs segments de deux cotés qui chacun présente une barrette à gicleur.

4. Dispositif selon une des revendications 1 à 3, **caractérisé en ce que** la position des deux parties de l'élément de douche (16) est ajustable, en option séparément l'un de l'autre.

5. Dispositif selon une des revendications précédentes, **caractérisé en ce que** au choix ou bien le dispositif de douche (15) est ajustable par rapport au dispositif porteur (2) fixe, ou bien le dispositif porteur (2) par rapport au dispositif de douche (15) fixe, ou encore le dispositif porteur (2) et l'élément de douche (15) sont ajustables l'un par rapport à l'autre.

6. Dispositif selon une des revendications précédentes, **caractérisé en ce que** au moins un appareil à ultrasons (18) est prévu, localisé à l'intérieur du bassin (14), au choix stationnaire ou mobile.

7. Dispositif selon une des revendications précédentes, **caractérisé en ce que** plusieurs éléments de douche (16) sont disposés à différents niveaux par rapport à la profondeur du bassin (14).

8. Dispositif selon une des revendications précédentes, **caractérisé en ce que** la hauteur du, au moins un, élément de douche (16) est ajustable dans le bassin (14).

9. Dispositif selon une des revendications 6 à 8, **caractérisé en ce que** l'appareil à ultrasons (18) contient des sources à ultrasons (19) qui sont situées de biais par rapport à l'orientation horizontale du dispositif porteur (2).

10. Dispositif selon une des revendications 6 à 9, **caractérisé en ce que** les sources à ultrasons (19) sont arrangées en rotation.

11. Procédé pour le nettoyage des plaquettes cassables (6) au moyen d'un dispositif, les plaquettes (6) étant fixées par un de leurs cotés à un dispositif porteur (2) et un intervalle (7) étant formé entre chaque paire de plaquettes voisines, et le dispositif étant constitué par un dispositif de douche (15), grâce auquel fluide est injecté dans les intervalles (7), ainsi que d'un bassin (14) qui peut être rempli de fluide et de dimensions telles qu'il intègre le dispositif porteur (2), le dispositif de douche (15) comprenant au moins un élément de douche (16) contenant plusieurs gicleurs, lequel est conçu en deux parties, chaque partie étant localisée latéralement sur le grand coté du bassin (14) de telle manière que les deux parties sont parallèles à l'axe longitudinal du bassin et en opposition par rapport à la direction de leurs flux, **caractérisé par** les étapes de procédé suivantes:
a) introduction du dispositif porteur (2) avec les plaquettes (1) dans le bassin (14) vide ou rempli en partiellement; et
b) mise en oeuvre du processus de nettoyage par le dispositif de douche (15), les gicleurs du, au moins un, élément de douche (16), positionnés en vis-à-vis direct n'étant pas activés en même temps.

12. Procédé selon la revendication 11, **caractérisé en ce qu'**il comprend une étape c) de procédé supplémentaire consistant en la mise en oeuvre du processus de nettoyage avec un dispositif à ultrasons (18) localisé dans le bassin en présence de fluide.

13. Procédé selon la revendication 12, **caractérisé ce que** l'étape b) du procédé est effectuée avant et après l'étape c) du procédé.

14. procédé selon la revendication 12, **caractérisé en ce que** les étapes b) et c) du procédé sont effectuées plusieurs fois l'une après l'autre.
